# EUROPEAN PATENT APPLICATION

(11) **EP 2 098 478 A1**
(43) Date of publication of application: **09.09.2009**
(21) Application number: 08152482.9
(22) Date of filing: 07.03.2008
(51) Int. Cl.: B81C 1/00

(54) **Manufacturing micro components including a cover structure.**

(71) Applicant: Nederlandse Organisatie voor toegepast-natuurwetenschappelijk onderzoek TNO, 2628 VK Delft (NL)
(72) Inventor: Korbee, Roland Alexander, 6133 VR Sittard (NL); Bolt, Pieter Jan, 1115 DI Duivendrecht (NL); Bullema, Jan Eite, 5706 KT Helmond (NL)
(74) Representative: Hatzmann, Martin

(57) **Abstract**

Method for manufacturing components (5) comprising the steps of manufacturing a carrier layer (4) including a plurality of said components, and manufacturing a cover structure and applying it to the wafer. The cover structure has the shape of a preformed foil (2), arranged to cover over each individual component and to be adhered to the wafer around each individual component. The foil shaped cover structure (2) is manufactured using at least one moulding part (1). The mould (1), including the cover structure (2), is moved to the wafer (4) with the plurality of components. Via the mould, the cover structure is pressed to the wafer and the cover structure is adhered to the wafer in the areas (7) around the individual components, after which the cover structure is released from its mould by means of gas or air pressure.

## Description

The present invention concerns a method for manufacturing components like e.g. micro electronic, micro mechanical etc. components. Such a generally known method may comprise the steps of:
- manufacturing a carrier layer or wafer including a plurality of said components;
- manufacturing a cover structure and applying it to the wafer.

US2004082115 (e.g. see figures 15 - 21) discloses a method for fabricating a mould which is used for manufacturing protective caps which are applied to a wafer for covering microelectromechanical (MEM) components. In the known method the cover caps are manufactured by injection moulding in a two mould system. After the curing of the caps the lower mould is removed while the upper mould, including the caps, are moved towards the wafer where the caps are released (downwards) from the upper mould and adhered to the wafer.

Disadvantageous is that releasing the (plurality of) caps from the upper mould requires a plurality of thin ejector pins, running through small bores, which release system is susceptible to malfunctioning.

One aim is to provide a method which is much more robust and less sensitive to interference.

Another aim is to provide a much simpler design for the cover structure.

Another aim is to provide to use a semi-manufactured base material like a foil.

Yet another aim is the use of a much simpler mould.

According to the invention it is preferred, that in a method for manufacturing components like e.g. micro electronic, micro mechanical etc. components, the method comprising the steps of:
- manufacturing a carrier layer or wafer including a plurality of said components;
- manufacturing a cover structure and applying it to the wafer,
the cover structure has the shape of a preformed foil, arranged to cover over each individual component and to be adhered to the wafer around each individual component.

It is preferred to perform the steps of:
- manufacturing the foil shaped cover structure using at least one moulding part (or mould);
- moving the relevant moulding part, including the cover structure, to the wafer with the plurality of components;
- pressing, via the moulding part, the cover structure to the wafer and adhering the cover structure to the wafer in the areas around the individual components;
- releasing the cover structure from the moulding part.

Due to the foil shape of the cover structure this integral, gas tight structure can easily be released from its mould by means of gas or air pressure in stead of ejector pins etc.

Hereinafter the method will be illustrated referencing to an exemplary embodiment of a system which is arranged for performing the inventive method as outlined above.
- Figure 1: illustrates a mould including a foil shaped cover structure made therein;
- Figure 2: shows the mould and cover structure being moved above a wafer, including a plurality of micro components, and its support structure;
- Figure 3: shows the mould pressing the cover structure to the wafer;
- Figure 4: illustrates releasing the cover structure form the mould;
- Figure 5: shows the resulting wafer, still resting upon its support structure, and the cover structure released from its mould;
- Figure 6: shows the released wafer and cover structure;
- Figure 7: illustrates the micro components including the cover structure, cut or sawn loose, resulting in a plurality of individual, covered micro components.

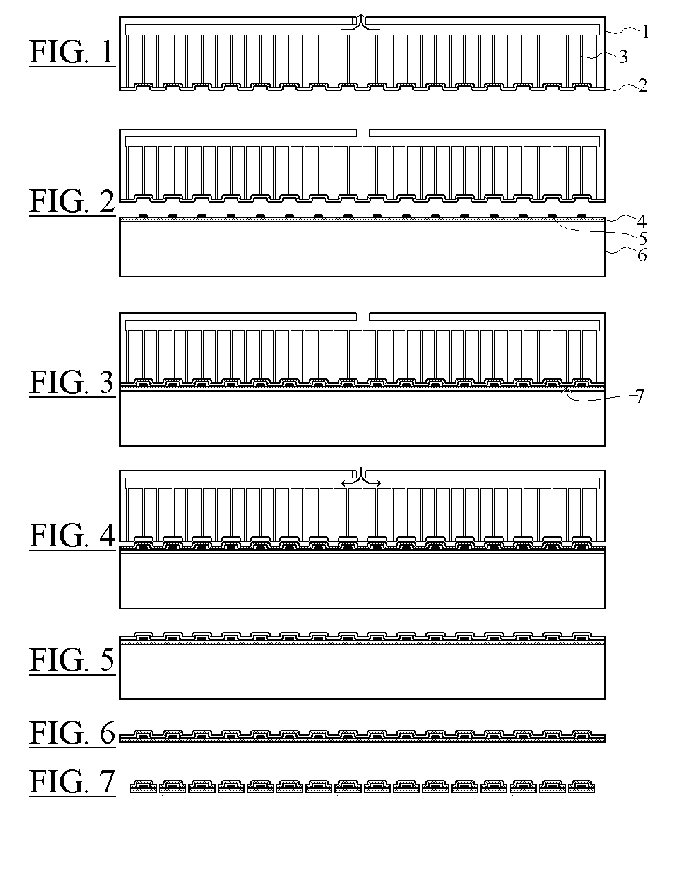

Figure 1 shows a (one-part) mould 1 including a foil shaped cover structure 2 made therein e.g. by vacuum forming: a flat foil is heated to a adequate softening temperature and put to the structured mould side. By applying vacuum (see arrow) via a plurality of channels 3 the softened foil - e.g. made by a reinforced polyamide or a (nano) composite of a polyamide - will be attracted by the vacuum to the structured shape of the mould. Next the foil 2 is cooled down but remains in the mould 1.

It is noted that, as an alternative, the cover structure could be made by injection moulding, using a two-part mould: an upper moulding part and a lower moulding part. A relevant plastic, e.g. polyamide, is injected into the room between both moulding parts when closed. After cooling down the below moulding part is released and removed.

Figure 2 illustrates that, after the step of manufacturing a foil shaped cover structure using at least one mould, as outlined above and illustrated in figure 1, in next step the (upper) mould (part) 1 is placed above a wafer 4 including a plurality of micro components 5 which have to be covered. The wafer 4 is supported by a support structure 6.

Figure 3 shows pressing the mould 1 including the cover structure 2 to the wafer 4 and adhering the cover structure 2 to the wafer 4 in the areas 7 around the various individual components 5, thus covering over each individual micro component and sealing it on all sides.

The sealing may be performed by adhesion using an adhesive which can be applied to the below side of the foil 2 before or after being formed by the mould 1, e.g. formed by an appropriate copolymer layer like e.g. styrene maleic anhydride (SMA), to be used as a hotmelt adhesive.

Figure 4 illustrates releasing the cover structure from the mould by applying (gas or air) overpressure (see arrows) to the cover foil 2 via the channels 3.

Figure 5 shows the resulting wafer 4, still resting upon its support structure, including the cover structure 2 being adhered to the wafer 4 and released from its mould 1.

Figure 6 shows the released wafer 4 and cover structure 2.

Figure 7 illustrates the micro components 5 including the cover structure 2, being together cut or sawn loose, resulting in a plurality of individual, covered micro components 5.

The figures thus illustrate an exemplary system and method for manufacturing micro components 5 which is very robust and little sensitive to interference, provides a simple and reliable design for the cover structure 2, which may be made from a semi-manufactured base material (foil) and in which a quite simple mould can be used.

## Claims

1. Method for manufacturing components (5), the method comprising the steps of:
- manufacturing a carrier layer (4) including a plurality of said components;
- manufacturing a cover structure and applying it to the wafer,
**characterized in that**
the cover structure has the shape of a preformed foil (2), arranged to cover over each individual component and to be adhered to the wafer around each individual component.

2. Method according to claim 1, comprising the steps of:
- manufacturing the foil shaped cover structure (2) using at least one moulding part (1);
- moving the relevant moulding part (1), including the cover structure (2), to the wafer (4) with the plurality of components;
- pressing, via the moulding part, the cover structure to the wafer and adhering the cover structure to the wafer in the areas (7) around the individual components;
- releasing the cover structure from the moulding part.

3. Method according to claim 2, wherein the foil shaped cover structure is released from its moulding part by means of gas or air pressure.

4. System arranged for performing the method according to any claim 1 - 3.
